# EUROPÄISCHE PATENTSCHRIFT

(11) **EP 1 278 239 B1**
(45) Veröffentlichungstag und Bekanntmachung des Hinweises auf die Patenterteilung: **21.09.2005**
(21) Anmeldenummer: 01117545.2
(22) Anmeldetag: 20.07.2001
(51) Int. Cl.: H01L 21/32, H01L 21/8242, H01L 21/308, H01L 21/316

(54) **Verfahren zur Herstellung selbstjustierender Maskenschichten**
Process for forming self-adjusting masking layers
Procédé de formation de couches de masquage autoajustables

(43) Veröffentlichungstag der Anmeldung: 22.01.2003
(73) Patentinhaber: Infineon Technologies AG, 81669 München (DE)
(72) Erfinder: Lichter, Gerd, 01471 Radeburg (DE)
(74) Vertreter: Kindermann, Peter

(56) Entgegenhaltungen:
- US-A- 4 679 299
- US-A- 5 618 751
- PROKSCHE H ET AL: "THE INFLUENCE OF NH4F ON THE ETCH RATES OF UNDOPED SIO2 IN BUFFERED OXIDE ETCH" JOURNAL OF THE ELECTROCHEMICAL SOCIETY, ELECTROCHEMICAL SOCIETY. MANCHESTER, NEW HAMPSHIRE, US, Bd. 139, Nr. 2, 1. Februar 1992 (1992-02-01), Seiten 521-524, XP000334389 ISSN: 0013-4651
- PROKSCHE H ET AL: "THE INFLUENCE OF NH4F ON THE ETCH RATES OF LOW PRESSURE CHEMICAL VAPOR DEPOSITION ARSENOSILICATE GLASSES IN BUFFERED OXIDE ETCH" JOURNAL OF THE ELECTROCHEMICAL SOCIETY, ELECTROCHEMICAL SOCIETY. MANCHESTER, NEW HAMPSHIRE, US, Bd. 140, Nr. 12, 1. Dezember 1993 (1993-12-01), Seiten 3611-3615, XP000430015 ISSN: 0013-4651

## Beschreibung

Die vorliegende Erfindung bezieht sich auf ein Verfahren zur Herstellung selbstjustierender Maskenschichten und insbesondere auf ein Verfahren zur Herstellung einer unverdichteten konformalen Maskenschicht, die auf Grund einer unterschiedlichen mechanischen Beanspruchung unterschiedliche Ätzraten bzw. eine selbstjustierende Rückätzung aufweist.

Aus der den Oberbegriff des Patentanspruchs 1 bildenden Druckschrift US-A-4679299 ist ein Verfahren zur Herstellung einer selbstjustierenden Maskenschicht bekannt, wobei zum Erzeugen von gestressten bzw. mechanisch beanspruchten Oxidbereichen in einer konformal abgeschiedenen CVD-Oxidschicht ein stufenförmiges Profil verwendet wird. Unter Verwendung einer HF-Ätzung werden hierbei in Abhängigkeit von der unterschiedlichen mechanischen Beanspruchung die gestressten Teilbereiche des Oxids selektiv entfernt.

Zur Verdeutlichung der Erfindung wird diese anhand eines Verfahrens zur Herstellung eines Grabenkondensators beschrieben, wie er in Halbleiter-Speicherzellen von integrierten Halbleiter-Schaltungen verwendet wird. Die Erfindung kann jedoch in gleicher Weise allgemein auf mikroelektronische, mikromechanische sowie Kombinationen aus mikroelektronischen und mikromechanischen Systemen mit einer derartigen selbstjustierenden Rückätzung angewendet werden.

Zur Veranschaulichung der vorliegenden Erfindung wird zunächst ein herkömmliches Verfahren zur Herstellung eines Grabenkondensators in einer dynamischen Halbleiter-Speicherzelle eines dynamischen Speichers DRAM beschrieben.

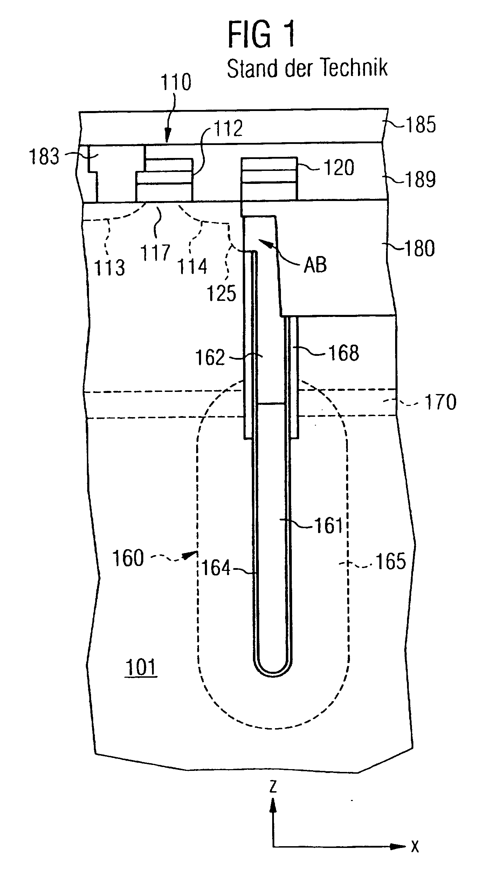

Figur 1 zeigt einen herkömmlichen Grabenkondensator, wie er insbesondere in einer DRAM-Halbleiter-Speicherzelle verwendet wird, und beispielsweise aus der Druckschrift US 5,945,704 bekannt ist. Eine derartige DRAM-Halbleiter-Speicherzelle besteht im Wesentlichen aus einem Kondensator 160, der in einem Substrat 101 ausgebildet ist. Das Substrat 101 ist beispielsweise mit p-Dotierstoffen wie zum Beispiel Bor leicht dotiert. Ein Graben wird üblicherweise mit Polysilizium 161 gefüllt, welches mit beispielsweise Arsen oder Phosphor stark n⁺-dotiert ist. Eine mit beispielsweise Arsen dotierte vergrabene Platte 165 befindet sich im Substrat 101 an einem unteren Bereich des Grabens. Üblicherweise wird das Arsen bzw. der Dotierstoff von einer Dotierstoffquelle wie z.B. einem Arsensilikatglas ASG, welches an den Seitenwänden des Grabens ausgebildet wird, in das Siliziumsubstrat 101 diffundiert. Das Polysilizium 161 und die vergrabene Platte 165 dienen hierbei als Elektroden des Kondensators 160, wobei eine dielektrische Schicht 164 die Elektroden des Kondensators voneinander trennt.

Die DRAM-Halbleiter-Speicherzelle gemäß Figur 1 besitzt darüber hinaus einen Feldeffekttransistor 110. Dieser üblicherweise als Auswahltransistor bezeichnete Transistor besitzt ein Gate 112 und Diffusionsgebiete 113 und 114 als Source und Drain. Die Diffusionsgebiete, die durch einen Kanal 117 voneinander beabstandet sind, werden üblicherweise durch Implantation von Dotierstoffen wie z.B. Phosphor ausgebildet. Ferner ist ein Kontaktdiffusionsgebiet 125 im Halbleitersubstrat 101 ausgebildet, welches den Kondensator 160 mit dem Auswahltransistor 110 über beispielsweise eine weitere elektrisch leitende Füllschicht 162 verbindet.

Ein Isolationskragen 168 wird an einem oberen Abschnitt bzw. oberen Bereich des Grabens ausgebildet. Der Isolationskragen 168 verhindert hierbei einen Leckstrom vom Kontakt-Diffusionsgebiet 125 zur vergrabenen Platte 165. Ein derartiger Leckstrom ist insbesondere in Speicherschaltungen unerwünscht, da er die Landungshaltezeit bzw. Retentionszeit einer Halbleiter-Speicherzelle verringert.

Gemäß Figur 1 besitzt die herkömmliche Halbleiter-Speicherzelle mit Grabenkondensator ferner eine vergrabene Wanne bzw. Schicht 170, wobei die Spitzenkonzentration der Dotierstoffe in der vergrabenen n-Wanne in etwa im unteren Ende des Isolationskragens 168 liegt. Die vergrabene Wanne bzw. Schicht 170 dient im Wesentlichen einer Verbindung der vergrabenen Platten 165 von einer Vielzahl von benachbarten DRAM-Halbleiter-Speicherzellen bzw. Kondensatoren 160 im Trägersubstrat 101, welches vorzugsweise aus Siliziumhalbleitermaterial besteht.

Eine Aktivierung des Auswahltransistors 110 durch Anlegen einer geeigneten Spannung an das Gate 112 ermöglicht im Wesentlichen einen Zugriff auf den Grabenkondensator 160, wobei üblicherweise das Gate 112 mit einer Wortleitung 120 und das Diffusionsgebiet 113 mit einer Bitleitung 185 im DRAM-Feld verbunden ist. Die Bitleitung 185 ist hierbei vom Diffusionsgebiet 113 durch eine dielektrische Isolationsschicht 189 getrennt und über einen Kontakt 183 elektrisch verbunden.

Ferner wird zur Isolierung einer jeweiligen Halbleiter-Speicherzelle mit dazugehörigem Grabenkondensator von angrenzenden Zellen eine flache Grabenisolation (STI, shallow trench isolation) 180 an der Oberfläche des HalbleiterSubstrats 101 ausgebildet. Gemäß Figur 1 kann beispielsweise die Wortleitung 120 oberhalb des Grabens und durch die flache Grabenisolation (STI) isoliert ausgebildet werden, wodurch man eine sogenannte gefaltete Bitleitungs-Architektur erhält.

Auf diese Weise erhält man eine Halbleiter-Speicherzelle, die einen minimalen Platzbedarf aufweist und somit für hochintegrierte Schaltungen optimal geeignet ist.

Nachteilig ist jedoch bei einer derartigen herkömmlichen Halbleiter-Speicherzelle, dass der Isolationskragen 168 üblicherweise nur in gleicher Höhe um den Graben angeordnet ist und somit in einem Anschlussbereich AB weiterhin unerwünschte Leckströme ins Trägersubstrat 101 auftreten können.

Grundsätzlich könnte dieser Isolationskragen 168 auch stufenförmig in seinen anderen Bereichen hochgezogen werden, um lediglich das Anschluss-Diffusionsgebiet 125 freizugeben, wobei jedoch zusätzliche und kostenaufwändige fotolithografische Schritte sowie Ätzschritte anzuwenden sind. Diese Schritte sind jedoch insbesondere bei hochintegrierten Schaltungen auf Grund von sogenannten Overlay-Problemen und "critical dimension"-Toleranzen sehr aufwändig und kostenintensiv.

Der Erfindung liegt daher die Aufgabe zu Grunde ein Verfahren zur Herstellung selbstjustierender Maskenschichten zu schaffen, mit dem mikroelektronische und mikromechanische Systeme einfach und kostengünstig hergestellt werden können.

Insbesondere liegt der Erfindung die Aufgabe zu Grunde ein Verfahren zur Herstellung einer selbstjustierenden Maskenschicht zu schaffen, bei der der vorstehend beschriebene Isolationskragen auf besonders einfache und kostengünstige Weise derart ausgebildet wird, dass sich ein verringerter Leckstrom und verbesserte Ladungshalteeigenschaften ergeben.

Erfindungsgemäß wird diese Aufgabe durch die Maßnahmen des Patentanspruchs 1 gelöst.

Insbesondere durch das Ausbilden eines Grabens mit einer zu maskierenden Oberfläche in einem Trägersubstrat, wobei die Graben-Oberfläche unterschiedliche Krümmungsradien aufweist, und einem nachfolgenden Ausbilden einer unverdichteten konformalen Isolationsschicht auf der Oberfläche derart, dass sich auf Grund der unterschiedlichen Krümmungsradien Bereiche mit unterschiedlicher mechanischer Beanspruchung in der Isolationsschicht ergeben, kann bei einer nachfolgend durchgeführten Ätzung auf Grund einer festgestellten Ätzratenabhängigkeit von Teilbereichen der Isolationsschicht mit unterschiedlicher mechanischer Beanspruchung eine sublithografische Strukturierung beispielsweise zum Ausbilden von Kontaktbereichen realisiert werden.

Vorzugsweise werden als konformale Isolationsschicht ein unverdichtetes Oxid und/oder auf Siliziumoxid basierte Gläser wie beispielsweise BPSG, PSG und Spin-on-Gläser ausgebildet. Derartige Materialien bzw. Schichten zeigen eine starke Abhängigkeit ihrer inneren mechanischen Beanspruchung bzw. ihres inneren Stresses hinsichtlich einer zu maskierenden Oberflächenstruktur. Durch Auswahl von jeweiligen Krümmungsradien auf der zu maskierenden Oberfläche können somit sublithografische Strukturen besonders einfach und kostengünstig realisiert werden.

Vorzugsweise wird Ozon-TEOS-Oxid als konformale Isolationsschicht in einem CVD-Verfahren bei einem Druck von ca. 40 Torr, einer Temperatur von ca. 400 Grad Celsius und einem Ozonfluss von ca. 4000 sccm abgeschieden, wobei die TEOS-Menge ca. 800 mg/min beträgt. Eine derartige konformal abgeschiedene Isolationsschicht weist als selbstjustierende Maskenschicht außerordentlich günstige Abhängigkeiten zwischen einer jeweiligen Ätzrate und der dazugehörigen mechanischen Beanspruchung bzw. einem zu Grunde liegenden Krümmungsradius der Oberflächenstruktur auf.

Vorzugsweise kann nach dem Rückätzen der selbstjustierenden Maskenschicht bzw. konformalen Isolationsschicht eine Verdichtung bei beispielsweise einer Temperatur von 850 bis 1000 Grad Celsius in einer Stickstoff- und/oder Stickstoff-/Sauerstoffatmosphäre durchgeführt werden, wodurch man für weitere Verfahrensschritte eine Unabhängigkeit der Ätzrate der selbstjustierenden Maskenschicht in Abhängigkeit von der mechanischen Beanspruchung bzw. der zu Grunde liegenden Krümmung der zu maskierenden Oberfläche erhält. Die einmal eingestellten Strukturen in der selbstjustierenden Maskenschicht können somit für spätere Verfahrensschritte fixiert werden.

Insbesondere bei einem Verhältnis Rₘₐₓ/Rₘᵢₙ ≤ 1/8, wobei Rₘₐₓ der Krümmungsradius mit maximaler mechanischer Beanspruchung und Rₘᵢₙ der Krümmungsradius mit minimaler mechanischer Beanspruchung in der Maskenschicht darstellt, erhält man eine ausreichend hohe Selektivität für das Rückätzen der Masken- bzw. Isolationsschicht, wodurch sich eine signifikante Strukturierung ergibt.

In den weiteren Unteransprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:
Figur 1 eine vereinfachte Schnittansicht einer Halbleiter-Speicherzelle mit Grabenkondensator gemäß dem Stand der Technik;
Figur 2 eine vereinfachte Schnittansicht einer Halbleiter-Speicherzelle mit Grabenkondensator und erfindungsgemäß ausgebildetem Isolationskragen;
Figuren 3A bis 3C vereinfachte Schnittansichten entlang einer Schnittachse I-I', II-II' und einer Oberfläche zur Veranschaulichung eines ersten Verfahrensschritts;
Figuren 4A bis 4C vereinfachte Schnittansichten entlang einer Schnittachse I-I', II-II' und einer Oberfläche zur Veranschaulichung eines weiteren Verfahrensschritts;
Figuren 5A und 5B vereinfachte Schnittansichten entlang einer Schnittachse I-I' und II-II' zur Veranschaulichung eines weiteren Verfahrensschritts;
Figuren 6A und 6B vereinfachte Schnittansichten entlang einer Schnittachse I-I' und II-II' zur Veranschaulichung eines weiteren Verfahrensschritts; und
Figuren 7A und 7B vereinfachte Schnittansichten entlang einer Schnittachse I-I' und II-II' zur Veranschaulichung eines weiteren Verfahrensschritts.

Die Erfindung wird nachfolgend anhand einer DRAM-Halbleiter-Speicherzelle beschrieben, wobei beispielsweise ein Isolationskragen als selbstjustierende Maskenschicht ausgebildet und strukturiert wird.

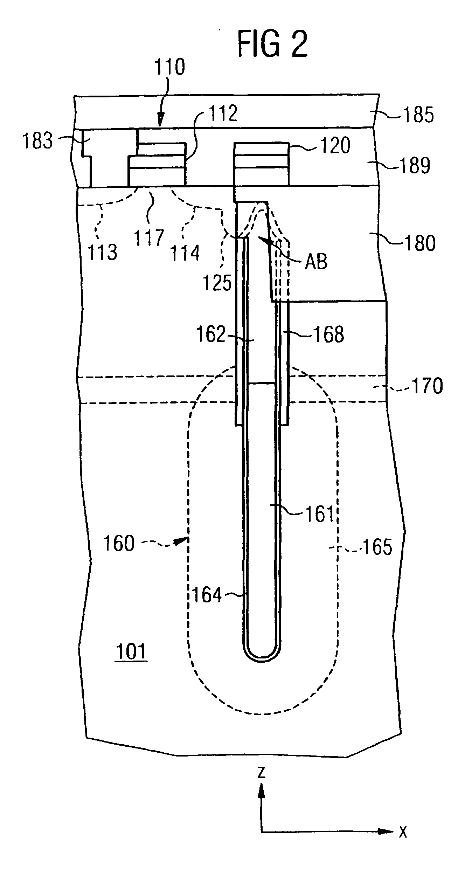

Figur 2 zeigt eine vereinfachte Schnittansicht einer Halbleiter-Speicherzelle mit Grabenkondensator und erfindungsgemäß ausgebildetem Isolationskragen, wobei gleiche Bezugszeichen gleiche Elemente oder Schichten wie in Figur 1 bezeichnen und auf eine wiederholte Beschreibung nachfolgend verzichtet wird.

Zur Vermeidung der eingangs beschriebenen Leckströme und zur Verbesserung der Ladungshalteeigenschaften in der Halbleiter-Speicherzelle wird der Isolationskragen 168 mit einem nachstehend beschriebenen Herstellungsverfahren ausgebildet, wobei insbesondere im Anschlussbereich AB gemäß Figur 2 eine (gestrichelt dargestellte) Isolationskragenstruktur realisiert wird.

Gemäß Figur 2 besitzt demzufolge der Isolationskragen 168 keine einheitliche Höhe, sondern variiert hinsichtlich seiner tatsächlichen Höhe in einer y-Richtung entsprechend der mit gestrichelten Linien dargestellten Isolationskragenstruktur. Erfindungsgemäß wird demzufolge der Isolationskragen 168 lediglich in einem kleinen Bereich der zum Kontakt-Diffusionsgebiet 125 gerichtet ist, voll geöffnet, während er in seinen weiteren y-Richtungen im Wesentlichen ansteigt und das Kontakt-Füllmaterial 162 nahezu vollständig umschließt, wodurch sich weiter verbesserte Ladungshalteeigenschaften und verringerte Leckströme ergeben.

Zur Veranschaulichung werden nachfolgend wesentliche Verfahrensschritte zur Herstellung einer derartigen selbstjustierenden Maskenschicht beispielhaft beschrieben.

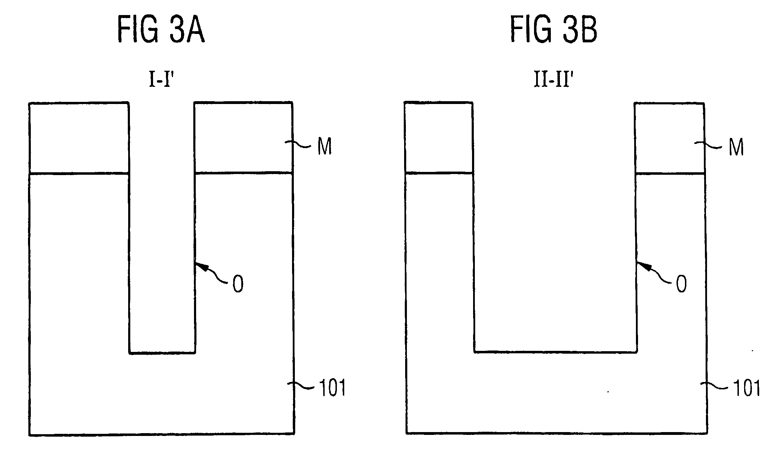

Figuren 3A bis 3C zeigen vereinfachte Schnittansichten entlang einer Schnittachse I-I', II-II' und entlang einer Oberfläche bzw. x-y-Ebene eines Trägersubstrats zur Veranschaulichung eines frühen Verfahrensschritts gemäß der vorliegenden Erfindung.

Gemäß Figuren 3A bis 3C wird zunächst auf einem Trägersubstrat 101, welches ein beliebiges Material darstellen kann und vorzugsweise aus einem Halbleitermaterial bzw. Silizium besteht, eine Maskenschicht M aufgetragen, die beispielsweise einen Fotolack-Resist aufweist. Alternativ kann diese Maskenschicht M eine sogenannte ARC-Schicht (anti reflective coating) mit einem Fotolack oder eine Hartmaske mit einer ARC-Schicht und einem Fotolack aufweisen.

Die Maske bzw. der Maskenschichtstapel M wird mittels herkömmlicher lithografischer Verfahren und eventuell notwendiger Ätzprozesse (für die ARC- bzw. Hartmaskenschicht) strukturiert. Anschließend wird die Struktur der Maskenschicht M durch eine geeignete Ätzung in das Trägersubstrat 101 übertragen, wodurch eine zu maskierende Oberfläche O im Trägersubstrat 101 ausgebildet wird. Gemäß Figuren 3A bis 3C handelt es sich bei der zu maskierenden Oberfläche O um eine Grabenoberfläche eines im Trägersubstrat 101 ausgebildeten Grabens.

Wesentlich für das erfindungsgemäße Verfahren zur Herstellung von selbstjustierenden Maskenschichten ist nunmehr die Form der zu maskierenden Oberfläche O. Genauer gesagt muss die zu maskierende Oberfläche O im Trägersubstrat 101 derart ausgebildet sein, dass sich unterschiedliche Krümmungsradien Rₘᵢₙ bis Rₘₐₓ ergeben.

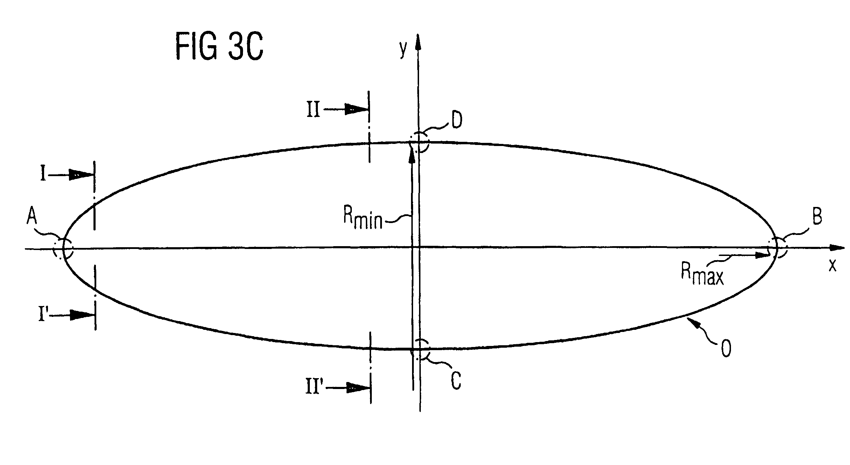

Gemäß Figur 3C besitzt eine Oberflächenschnittansicht bzw. Schnittansicht in x-y-ebene des Grabens eine elliptische Form, wobei die Scheitelpunkte A und B der Ellipse einen Krümmungsradius Rₘₐₓ und die Scheitelpunkte C und D einen Krümmungsradius Rₘᵢₙ aufweisen. Die Figuren 3A und 3B zeigen die dazugehörigen Schnittansichten entlang der Schnittlinien I-I' und II-II' gemäß Figur 3C. Alternativ können jedoch auch beliebige andere Strukturen als zu maskierende Oberflächenstrukturen verwendet werden.

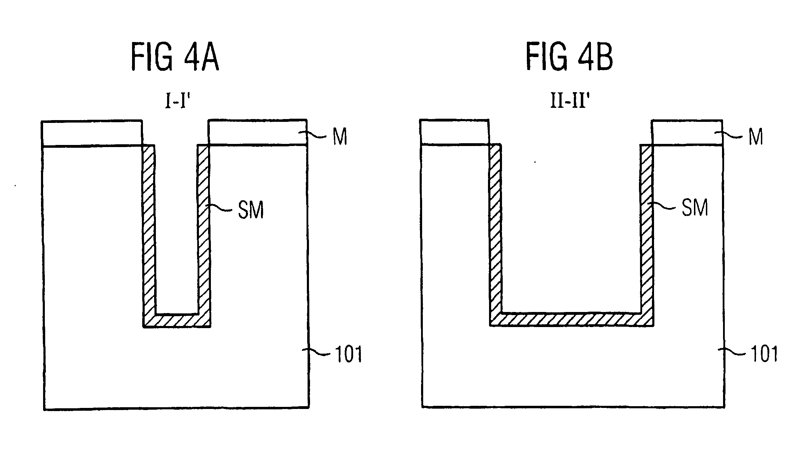

Figuren 4A bis 4C zeigen vereinfachte Schnittansichten entlang einer Schnittachse I-I', II-II' und einer Oberfläche bzw. x-y-Ebene zur Veranschaulichung eines weiteren Verfahrensschritts, wobei gleiche Bezugszeichen wiederum gleiche oder entsprechende Schichten bzw. Elemente wie in Figuren 3A bis 3C bezeichnen und auf eine wiederholte Beschreibung verzichtet wird.

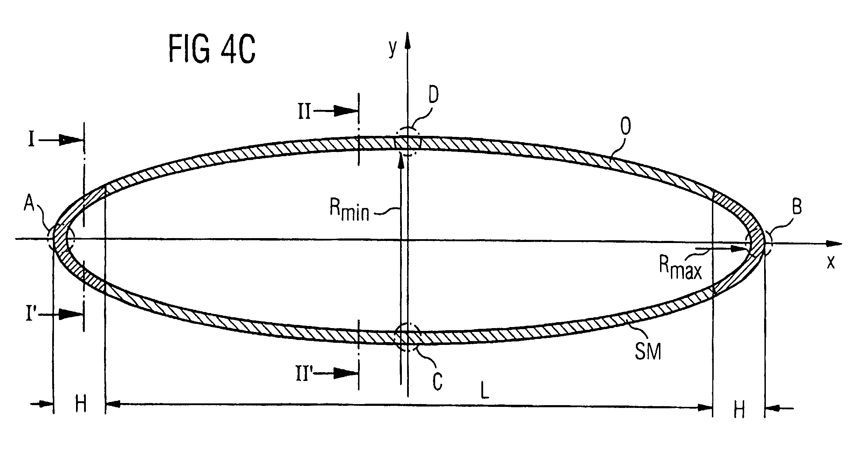

Gemäß Figuren 4A bis 4C wird in diesem Verfahrensschritt nunmehr eine unverdichtete konformale Isolationsschicht SM an der Oberfläche O des Trägersubstrats 101 derart ausgebildet, dass sich auf Grund der unterschiedlichen Krümmungsradien Rₘᵢₙ bis Rₘₐₓ Bereiche mit unterschiedlicher mechanischer Beanspruchung in der Isolationsschicht SM ergeben. Genauer gesagt wird gemäß Figur 4C in einem Bereich L auf Grund der zu Grunde liegenden Krümmungsradien eine unverdichtete konformale Isolationsschicht SM mit geringer mechanischer Beanspruchung ausgebildet, während in den Bereichen H, d.h. den Bereichen mit kleinen Krümmungsradien, die Isolationsschicht SM mit hoher mechanischer Beanspruchungen bzw. Stress ausgebildet wird.

Beispielsweise wird als konformale Isolationsschicht SM ein unverdichtetes Oxid und/oder ein auf Siliziumoxid basiertes Glas wie beispielsweise BPSG (Borphosphorsilikatglas), PSG (Phosphorsilikatglas), Spin-on-Glas usw. ausgebildet, die eine derartige krümmungsradiusabhängige Eigenschaft hinsichtlich ihrer mechanischen Beanspruchung aufweist. Unter einer konformalen Schicht bzw. konformal ausgebildeten Schicht ist hierbei eine Schicht mit konstanter Schichtdicke zu verstehen, die im Wesentlichen die gleiche Oberflächenstruktur aufweist wie eine zu Grunde liegende Untergrundschicht, d.h. die zu maskierende Oberfläche O.

Vorzugsweise wird im Schritt gemäß Figuren 4A bis 4C mittels eines CVD-Verfahrens (chemical vapor deposition) ein Ozon-TEOS-Oxid als konformale Isolationsschicht SM in einer herkömmlichen CVD-Kammer bei einem Druck von ca. 40 Torr, einer Suszeptortemperatur von beispielsweise 400 Grad Celsius und einem Ozonfluss von ca. 4000 sccm abgeschieden. Die TEOS-Menge (Tetraethylorthosilikat) beträgt ca. 800 mg/min.

Nach dieser konformalen Oxidabscheidung kann optional ein Rückätzschritt notwendig sein, um beispielsweise die selbstjustierende Maskenschicht bzw. die konformale Isolationsschicht SM außerhalb der zu maskierenden Oberflächenstruktur O zu entfernen. Alternativ sind auch sogenannte Lift-off-Prozesse anwendbar.

Insbesondere bei der Verwendung von Ozon-TEOS-Oxid ist hervorzuheben, dass das Oxid noch nicht vollständig verdichtet abgeschieden bzw. ausgeheilt wird, da ansonsten eine Ätzratenselektivität in Abhängigkeit von einer mechanischen Beanspruchung bzw. einem mechanischen Stress in der Schicht verloren geht. Je nach Prozessführung kann die Abscheidung auch vor der Entfernung der Maskenschicht bzw. des Maskenschichtstapels M oder einzelner Schichten hiervon erfolgen.

Wesentlich für das vorliegende Herstellungsverfahren ist unabhängig von der konkreten Prozesswahl das Ausbilden einer unverdichteten konformalen Isolationsschicht, die entsprechend ihrer Unterlage bzw. zu maskierenden Oberfläche O unterschiedliche Krümmungsradien aufweist. Hierbei kann wiederum je nach gewählter Prozessvariante die Oxidschicht SM nur noch in den senkrecht oder in anderem Winkel größer Null Grad zur Substratoberfläche befindlichen Strukturen erhalten bleiben oder alternativ dazu auch auf den parallel zur Substartoberfläche verlaufenden Schichten der Struktur erhalten bleiben. Insbesondere zur Realisierung eines Isolationskragens 168 ist auch eine weitere Bearbeitung möglich bzw. notwendig.

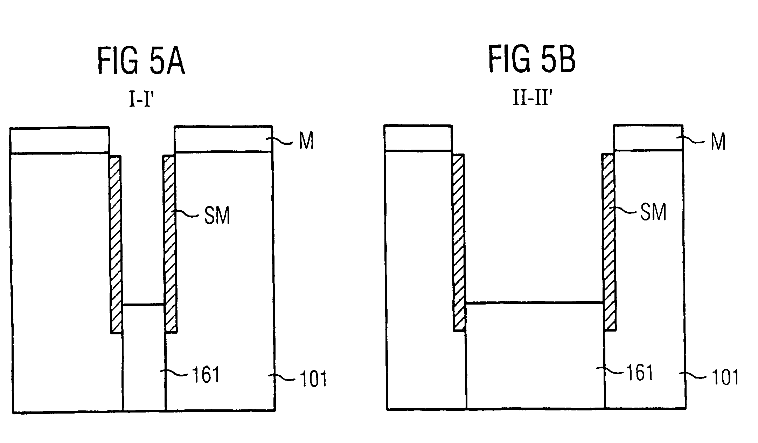

Figuren 5A und 5B zeigen vereinfachte Schnittansichten entlang einer Schnittachse I-I' und II-II' zur Veranschaulichung eines derartigen weiteren Verfahrensschritts, wobei gleiche Bezugszeichen gleiche oder entsprechende Elemente bzw. Schichten wie in Figuren 3 bis 4 bezeichnen und auf eine wiederholte Beschreibung nachfolgend verzichtet wird.

Gemäß Figuren 5A und 5B wird beispielsweise zur Ausbildung eines Grabenkondensators die konformale Isolationsschicht bzw. selbstjustierende Maskenschicht SM zunächst anisotrop geätzt, wodurch der Grabenboden frei gelegt wird. Anschließend wird ein eigentlicher Graben im Trägersubstrat 101 ausgebildet und mit der Polysilizium-Füllschicht 161 aufgefüllt. Zur Vereinfachung der Darstellung wurde auf die dielektrische Schicht 164, die sich zwischen dem Trägersubstrat und der Polysilizium-Füllschicht 161 befindet, verzichtet. Bis zu diesem Zeitpunkt weist die selbstjustierende Maskenschicht keinen Unterschied zu einer herkömmlich ausgebildeten Maskenschicht auf.

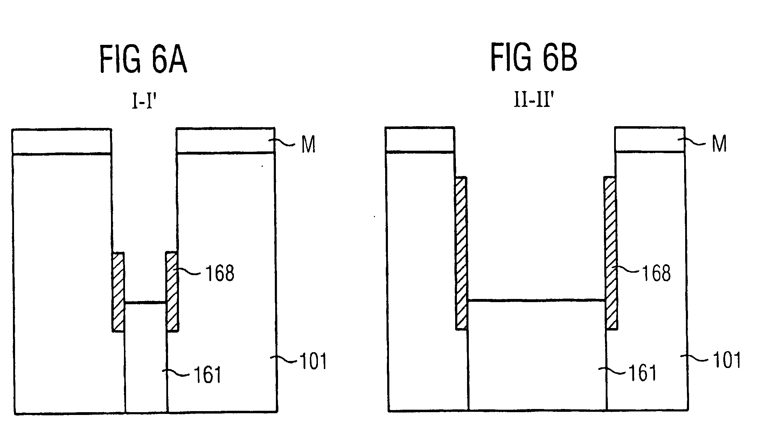

Figuren 6A und 6B zeigen vereinfachte Schnittansichten entlang einer Schnittachse I-I' und II-II' zur Veranschaulichung eines selbstjustierenden Rückätzschrittes, wobei gleiche Bezugszeichen wiederum gleiche oder entsprechende Schichten wie in Figuren 3 bis 5 darstellen und auf eine wiederholte Beschreibung nachfolgend verzichtet wird.

Gemäß Figuren 6A und 6B findet nunmehr eine selbst justierende Rückätzung zum Entfernen von Teilbereichen der Isolationsschicht bzw. selbstjustierenden Maskenschicht SM in Abhängigkeit von der unterschiedlichen mechanischen Beanspruchung in der Isolationsschicht statt. Gemäß Figur 6A wird demzufolge die selbstjustierende Maskenschicht SM in dem Bereich H mit hoher mechanischer Beanspruchung auf Grund des geringen Krümmungsradius wesentlich stärker zurückgeätzt als die selbe Schicht in dem Bereich L mit geringer mechanischer Beanspruchung auf Grund eines großen Krümmungsradius. Eine derartige Ätzung kann dabei sowohl eine adäquate Nassätzung als auch eine trockenchemische eventuell plasmaunterstützte Ätzung sein. Wesentlich ist, dass die gewünschten Ätzratenunterschiede in Abhängigkeit vom Krümmungsradius der zu maskierenden Struktur bzw. der Grabenoberfläche O durch die Ätzung hervortreten.

Vorzugsweise erfolgt die Rückätzung nasschemisch als BHF-Atzschritt bei ca. 20 Grad Celsius. Die Ätzrate beträgt hierbei ca. 20 nm/Minute auf Blankscheiben. Eine ausreichende Selektivität der Rückätzung auf Grund der unterschiedlichen mechanischen Beanspruchung bzw. der unterschiedlichen zu Grunde liegenden Krümmungsradien erhält man, wenn ein Verhältnis Rₘₐₓ/Rₘᵢₙ ≤ 1/8 ist, wobei Rₘₐₓ der Krümmungsradius mit maximaler mechanischer Beanspruchung und Rₘᵢₙ der Krümmungsradius mit minimaler mechanischer Beanspruchung in der Isolationsschicht bzw. selbstjustierenden Maskenschicht SM ist. Vorzugsweise wird insbesondere bei Ausbildung von DRAM-Halbleiter-Speicherzellen eine elliptische Form des Grabens in x-y-Ebene gewählt.

Nach dem Rückätzen der selbstjustierenden Maskenschicht kann ein Verdichten der Schicht durchgeführt werden, wobei vorzugsweise bei einer Temperatur von ca. 850 Grad Celsius bis 1000 Grad Celsius in einer Stickstoff- und/oder Stickstoff/Sauerstoff-Atmosphäre verdichtet bzw. ausgeheilt wird. Das Verdichten wird beispielsweise in einem Ofenprozess oder einem RTP-Prozess (rapid thermal process) durchgeführt. Auf diese Weise erhält man den in Figuren 6A und 6B dargestellten Isolationskragen 168, der auf Grund seiner Verdichtung nunmehr keine oder nur sehr geringe Ätzratenunterschiede in Abhängigkeit vom mechanischen Stress bzw. der zu Grunde liegenden Geometrie (Krümmungsradius) aufweist. Eine weitergehende Prozessierung kann demzufolge ohne Veränderung der Struktur bzw. jeweiligen Höhen und Tiefen des Isolationskragens 168 durchgeführt werden.

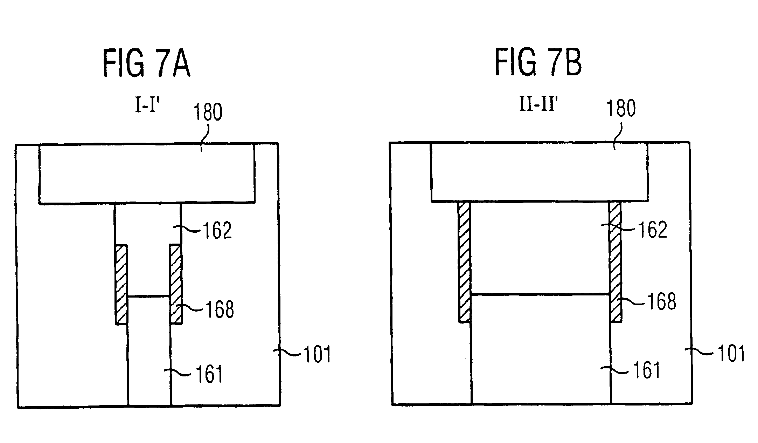

Figuren 7A und 7B zeigen vereinfachte Schnittansichten entlang einer Schnittachse I-I' und II-II' zur Veranschaulichung weiterer Verfahrensschritte, wobei gleiche Bezugszeichen gleiche oder entsprechende Elemente bzw. Schichten wie in Figuren 3 bis 6 bezeichnen und auf eine wiederholte Beschreibung nachfolgend verzichtet wird.

Gemäß Figuren 7A und 7B kann der Graben nunmehr mit einer weiteren elektrisch leitenden Füllschicht 162 zur Realisierung eines Anschlusskontakts zum Kontaktdiffusionsgebiet 125 aufgefüllt werden, wobei eine flache Grabenisolierung (shallow trench isolation, STI) 180 eine unbeabsichtigte Kontaktierung mit dem Trägersubstrat 101 verhindert. Auf diese Weise erhält man bei entsprechender Anordnung nur an der Stelle des Auswahltransistors 110 bzw. des Kontaktdiffusionsgebiets 125 einen Kontakt mit dem Trägersubstrat 101, während der übrige Bereich vollkommen vom Isolationskragen 168 eingeschlossen ist. Leckströme können dadurch weiter verringert werden, weshalb eine Ladungshaltezeit insbesondere in Halbleiter-Speicherzellen verbessert ist.

Mit dem vorstehend beschriebenen Herstellungsverfahren können somit Prozessschritte und Kosten eingespart werden, wobei insbesondere Lithografie-, Justage- und Strukturgrößenkontroll-Schritte sowie Ätzungen, Lackveraschung, Reinigungen usw. entfallen können. Insbesondere kann auf Grund der Selbstjustage eine Größe beispielsweise eines Kontaktbereichs sowie seine Positionierung deutlich kleiner bzw. genauer sein, als dies mit lithografischen Methoden üblicherweise realisierbar war.

Die Erfindung wurde vorstehend anhand einer DRAM-Halbleiter-Speicherzelle mit einem Isolationskragen beschrieben. Sie ist jedoch nicht darauf beschränkt und umfasst vielmehr alle weiteren Verfahren zur Herstellung von mikroelektronischen und/oder mikromechanischen Bauelementen, in denen eine selbstjustierende Maskenschicht verwendet wird.

### Bezugszeichenliste

- 101: Trägersubstrat
- 160: Grabenkondensator
- 161, 162: Füllmaterial
- 164: dielektrische Schicht
- 165: vergrabene Platte
- 168: Isolationskragen
- 170: vergrabene Wanne
- 180: flache Grabenisolierung
- 183: Kontakt
- 185: Bitleitung
- 189: Isolierschicht
- 110: Auswahltransistor
- 112: Gate
- 113: Source
- 114: Drain
- 117: Kanal
- 120: Wortleitung
- 125: Kontakt-Diffusionsgebiet
- AB: Anschlussbereich
- M: Maskenschicht (-stapel)
- O: zu maskierende Oberfläche
- A, B, C, D: Scheitelpunkte
- Rₘᵢₙ, Rₘₐₓ: Krümmungsradien
- SM: selbstjustierende Maskenschicht
- H, L: Bereiche mit hoher, geringer mechanischer Beanspruchung

## Patentansprüche

1. Verfahren zur Herstellung einer selbstjustierenden Maskenschicht mit den Schritten:
a) Ausbilden einer zu maskierenden Oberfläche (O), wobei die Oberfläche (O) unterschiedliche Krümmungsradien (Rₘₐₓ, Rₘᵢₙ) aufweist;
b) Ausbilden einer unverdichteten konformalen Isolationsschicht (SM), die als selbstjustierende Maskenschicht dient, auf der Oberfläche (O) derart, dass sich auf Grund der unterschiedlichen Krümmungsradien (Rₘᵢₙ, Rₘₐₓ) Bereiche (H, L) mit unterschiedlicher mechanischer Beanspruchung in der Isolationsschicht (SM) ergeben; und
c) Durchführen einer selbstjustierenden Rückätzung zum Entfernen von Teilbereichen der Isolationsschicht (SM) in Abhängigkeit von der unterschiedlichen mechanischen Beanspruchung in der Isolationsschicht (SM), wobei die Ätzrate der Isolationsschicht von der mechanischen Beanspruchung der Schicht abhängig ist, **dadurch gekennzeichnet, dass** in Schritt a) ein Graben in einem Trägersubstrat (101) ausgebildet wird und die zu maskierende Oberfläche (O) eine Grabenoberfläche darstellt.

2. Verfahren nach Patentanspruch 1,
**dadurch gekennzeichnet, dass** in Schritt b) als konformale Isolationsschicht (SM) unverdichtete Oxide und/oder auf Siliziumoxid basierte Gläser wie beispielsweise BPSG, PSG und Spin-on-Gläser ausgebildet werden.

3. Verfahren nach einem der Patentansprüche 1 oder 2,
**dadurch gekennzeichnet, dass** in Schritt b) ein Ozon-TEOS-Oxid als konformale Isolationsschicht (SM) abgeschieden wird.

4. Verfahren nach Patentanspruch 3,
**dadurch gekennzeichnet, dass** das Ozon-TEOS-Oxid mittels eines CVD-Verfahrens bei einem Druck von ca. 40 Torr, einer Temperatur von ca. 400 Grad Celsius und einem Ozonfluss von 4000 sccm abgeschieden wird, wobei die TEOS-Menge ca. 800 mg/min beträgt.

5. Verfahren nach einem der Patentansprüche 1 bis 4,
**gekennzeichnet durch** den weiteren Schritt d) Verdichten der konformalen Isolationsschicht (SM) nach dem Rückätzen in Schritt c).

6. Verfahren nach Patentanspruch 5,
**dadurch gekennzeichnet, dass** das Verdichten bei einer Temperatur von ca. 850 Grad Celsius bis 1000 Grad Celsius in einer Stickstoff- und/oder Sticks-/Sauerstoffatmosphäretoff durchgeführt wird.

7. Verfahren nach Patentanspruch 5 oder 6,
**dadurch gekennzeichnet, dass** das Verdichten in einem Ofen- oder RTP-Prozess durchgeführt wird.

8. Verfahren nach einem der Patentansprüche 1 bis 7,
**dadurch gekennzeichnet, dass** in Schritt c) eine isotrope Nassätzung durchgeführt wird.

9. Verfahren nach einem der Patentansprüche 1 bis 8,
**dadurch gekennzeichnet, dass** eine Oberflächenschnittansicht der zu maskierenden Oberfläche (O) eine elliptische Form aufweist.

10. Verfahren nach einem der Patentansprüche 1 bis 9,
**dadurch gekennzeichnet, dass** ein Verhältnis Rₘₐₓ/Rₘᵢₙ ≤ 1/8 ist, wobei Rmax der Krümmungsradius mit maximaler und Rₘᵢₙ der Krümmungsradius mit minimaler mechanischer Beanspruchung in der Isolationsschicht (SM) darstellt.

11. Verfahren nach einem der Patentansprüche 1 bis 10,
**dadurch gekennzeichnet, dass** es zur Ausbildung eines Kontaktes von einem Grabenkondensator (160) zu einem Auswahltransistor (110) in einer DRAM-Speicherzelle verwendet wird.

## Claims

1. Method for production of a self-adjusting mask layer having the following steps:
a) formation of a surface (O) to be masked, with the surface (O) having different radii of curvature (Rₘₐₓ, Rₘᵢₙ);
b) formation of an uncompressed conformal isolation layer (SM), which is used as a self-adjusting mask layer on the surface (O) in such a way that the different radii of curvature (Rₘᵢₙ, Rₘₐₓ) results in areas (H, L) with different mechanical loads in the isolation layer (SM); and
c) carrying out a process of self-adjusting etching back to remove subareas of the isolation layer (SM) as a function of the different mechanical loads in the isolation layer (SM), with the etching rate of the isolation layer being dependent on the mechanical loads in the layer, **characterized in that**, in step a), a trench is formed in a mount substrate (101), and the surface (O) to be masked represents a trench surface.

2. Method according to Patent Claim 1, **characterized in that**, in step b), uncompressed oxides and/or glasses based on silicon oxide such as BPSG, PSG and spin-on glasses are used as the conformal isolation layer (SM).

3. Method according to one of Patent Claims 1 or 2, **characterized in that**, in step b), an ozone TEOS oxide is deposited as the conformal isolation layer (SM).

4. Method according to Patent Claim 3, **characterized in that** the ozone TEOS oxide is deposited by means of a CVD method at a pressure of about 40 torr, a temperature of about 400 degrees Celsius, and with an ozone flow of 4000 sccm, with the TEOS flow rate being about 800 mg/min.

5. Method according to one of Patent Claims 1 to 4, **characterized by** the further step d) of compression of the conformal isolation layer (SM) after the etching back process in step c).

6. Method according to Patent Claim 5, **characterized in that** the compression process is carried out at a temperature of about 850 degrees Celsius to 1000 degrees Celsius in a nitrogen and/or nitrogen/oxygen atmosphere.

7. Method according to Patent Claim 5 or 6, **characterized in that** the compression process is carried out in an oven or RTP process.

8. Method according to one of Patent Claims 1 to 7, **characterized in that** isotropic wet etching is carried out in step c).

9. Method according to one of Patent Claims 1 to 8, **characterized in that** a surface section layer of the surface (O) to be masked has an elliptic shape.

10. Method according to one of Patent Claims 1 to 9, **characterized by** a ratio (Rₘₐₓ/Rₘᵢₙ ≤ 1/8, where Rₘₐₓ represents the radius of curvature with the maximum mechanical load in the isolation layer (SM), and Rₘᵢₙ represents the radius of curvature with the minimum mechanical load in the isolation layer (SM).

11. Method according to one of Patent Claims 1 to 10, **characterized in that** the method is used to form a contact from a trench capacitor (160) to a selection transistor (110) in a DRAM memory cell.

## Revendications

1. Procédé de production d'une couche de masque à auto-alignement comprenant les stades dans lesquels :
a) on constitue une surface (O) de masquage, la surface (O) ayant des rayons (Rₘₐₓ, Rₘᵢₙ) de courbure différents ;
b) on constitue une couche (SM) isolante conforme et non tassée qui sert de couche de masque à auto-alignement sur la surface (O), de façon à ce que, sur la base de la différence des rayons (Rₘₐₓ, Rₘᵢₙ) de courbure, il se produise des zones (H, L) sollicitées différemment du point de vue mécanique dans la couche (SM) isolante ; et
c) on effectue une attaque latérale à auto-alignement pour éliminer des zones partielles de la couche (SM) isolante en fonction de la différence de sollicitation mécanique dans la couche (SM) isolante, la vitesse d'attaque de la couche isolante dépendant de la sollicitation mécanique de la couche,
**caractérisé en ce qu'**au stade a) on constitue un sillon dans un substrat (101) support et la surface (O) à masquer représente une surface du sillon.

2. Procédé suivant la revendication 1,
**caractérisé en ce qu'**au stade b) on constitue en tant que couche (SM) isolante conforme des verres à base d'oxyde non tassé et/ou d'oxyde de silicium, comme par exemple des verres BPSG, PSG et Spin-on.

3. Procédé suivant l'une des revendications 1 ou 2,
**caractérisé en ce qu'**au stade b) on dépose un ozone-TEOS-oxyde en tant que couche (SM) isolante conforme.

4. Procédé suivant la revendication 3,
**caractérisé en ce que** l'on dépose la couche d'ozone-TEOS-oxyde au moyen d'un procédé CVD sous une pression d'environ 40 torrs à une température d'environ 400°C et à un débit d'ozone de 4 000 cm³ à la seconde, la quantité de TEOS étant d'environ 800 mg/min.

5. Procédé suivant l'une des revendications 1 à 4,
**caractérisé par** le stade d) supplémentaire, dans lequel on comprime la couche (SM) isolante conforme après l'attaque latérale au stade c).

6. Procédé suivant la revendication 5,
**caractérisé en ce que** l'on effectue la compression à une température d'environ 850 degrés Celsius à 1 000 degrés Celsius dans une atmosphère d'azote et/ou d'azote/oxygène.

7. Procédé suivant la revendication 5 ou 6,
**caractérisé en ce que** l'on effectue la compression dans un processus à four ou dans un processus RTP.

8. Procédé suivant l'une des revendications 1 à 7,
**caractérisé en ce qu'**au stade c) on effectue une attaque isotrope en voie humide.

9. Procédé suivant l'une des revendications 1 à 8,
**caractérisé en ce qu'**une vue en coupe de la surface (O) à masquer a une forme elliptique.

10. Procédé suivant l'une des revendications 1 à 9,
**caractérisé en ce qu'**un rapport (Rₘₐₓ, Rₘᵢₙ) est inférieur ou égal à 1/8, Rₘₐₓ étant le rayon de courbure ayant la sollicitation mécanique maximum et Rₘᵢₙ étant le rayon de courbure ayant la contrainte mécanique minimum dans la couche (SM) isolante.

11. Procédé suivant l'une des revendications 1 à 10,
**caractérisé en ce qu'**on l'utilise pour constituer un contact d'un condensateur (160) à sillon à un transistor (110) de sélection dans une cellule de mémoire DRAM.
